(19) Europäisches Patentamt
European Patent Office
Office européen des brevets

(11) **EP 4 553 520 A1**

(12) **EUROPEAN PATENT APPLICATION**
published in accordance with Art. 153(4) EPC

(43) Date of publication:
**14.05.2025 Bulletin 2025/20**

(21) Application number: **23834761.1**

(22) Date of filing: **30.06.2023**

(51) International Patent Classification (IPC):
*G01R 31/382* (2019.01)

(52) Cooperative Patent Classification (CPC):
**G01R 31/382**

(86) International application number:
**PCT/CN2023/104874**

(87) International publication number:
**WO 2024/007994 (11.01.2024 Gazette 2024/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **04.07.2022 CN 202210779541**

(71) Applicant: **Nio Battery Technology (Anhui) Co.,
Ltd.**
**Hefei, Anhui 230601 (CN)**

(72) Inventors:
• **WAN, Zhiwen**
  **Hefei, Anhui 230601 (CN)**
• **HE, Teng**
  **Hefei, Anhui 230601 (CN)**
• **CAI, Wei**
  **Hefei, Anhui 230601 (CN)**
• **HUA, Rui**
  **Hefei, Anhui 230601 (CN)**
• **CENG, Shizhe**
  **Hefei, Anhui 230601 (CN)**

(74) Representative: **Vossius & Partner
Patentanwälte Rechtsanwälte mbB
Siebertstrasse 3
81675 München (DE)**

(54) **BATTERY SYSTEM, AND SOH ESTIMATION METHOD THEREFOR, AND STORAGE MEDIUM**

(57) The disclosure relates to the technical field of vehicle batteries, and more specifically to a battery system including two systems of batteries, a state of health (SOH) estimation method for the battery system, and a computer storage medium. The battery system includes a first-system battery and a second-system battery. The method includes: A, performing constant-current charging on the battery system in an initial time period and a current time period, respectively, and recording a voltage characteristic curve for the first-system battery during the charging process; B, determining a feature point of a differential reciprocal dt/dV for the voltage characteristic curve, and calculating a state of charge and a state of health of the second-system battery corresponding to the feature point; and C, calculating a current capacity and a state of health of the first-system battery based at least on the state of charge and the state of health of the second-system battery.

*FIG. 2*

**Description**

**TECHNICAL FIELD**

The disclosure relates to the technical field of vehicle batteries, and more specifically to a battery system including two systems of batteries, a state of health (SOH) estimation method for the battery system, and a computer storage medium.

**BACKGROUND ART**

With the vigorous development and popularization of electric vehicles, users have increasingly high requirements for battery safety performance. Traction batteries currently used in the electric vehicles are mainly classified into lithium iron phosphate-system batteries (LFP) and nickel cobalt manganese-system batteries (NCM). As the lithium iron phosphate-system batteries have more excellent safety performance, more or more electric vehicles use the lithium iron phosphate-system batteries in recent years.

State of health (SOH) estimation for a vehicle battery is the core issue in a battery management system (BMS). Accurate estimation of a state of health of a battery facilitates the development of appropriate control strategies for the vehicle, thereby prolonging the service life of the battery and alleviating range anxiety of a user. A commonly used state of health estimation method is a two-point method, in which a high-point state of charge (SOC) and a low-point state of charge are located by means of an open-circuit voltage (OCV), and the overall state of health is calculated based on current integration. This method requires calculating an open-circuit voltage of a battery and obtaining a state of charge based on mapping of offline experiment results, thus requiring an OCV-SOC curve of the battery to have a large slope, so as to accurately map the open-circuit voltage to the state of charge after obtaining the open-circuit voltage.

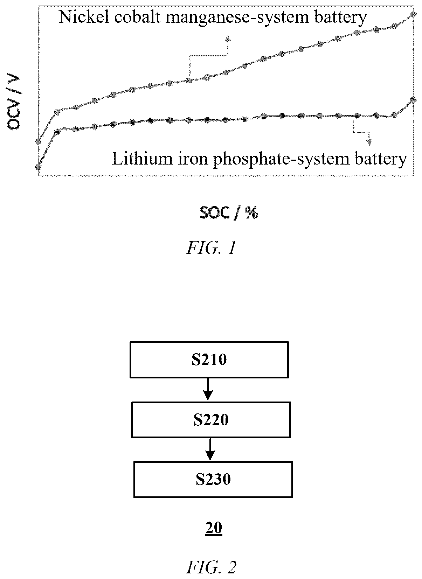

As shown in FIG. 1, the OCV-SOC curve of a lithium iron phosphate-system battery is exceptionally flat, and usually, an open-circuit voltage (OCV) value can be mapped to a wide range of state of charge (SOC) values. This requires that the lithium iron phosphate-system battery must be fully charged to determine its high-point state of charge. This limitation makes it difficult to accurately calculate the state of health of lithium iron phosphate batteries in the industry.

**SUMMARY**

In order to solve or at least alleviate one or more of the above problems, the following technical solutions are provided.

According to a first aspect of the disclosure, there is provided a state of health (SOH) estimation method for a battery system, where the battery system includes a first-system battery and a second-system battery, the method including: A, performing constant-current charging on the battery system in an initial time period and a current time period, respectively, and recording a voltage characteristic curve for the first-system battery during the charging process; B, determining a feature point of a differential reciprocal dt/dV for the voltage characteristic curve, and calculating a state of charge and a state of health of the second-system battery corresponding to the feature point; and C, calculating a current capacity and a state of health of the first-system battery based at least on the state of charge and the state of health of the second-system battery.

As an alternative or addition to the above solution, in the method according to an embodiment of the disclosure, step B includes: B1, performing a differential reciprocal dt/dV calculation on a voltage characteristic curve recorded in the initial time period, and determining a first feature point of a differential reciprocal curve, where the first feature point is a peak position of dt/dV within a first voltage interval; B2, calculating a first state of charge of the second-system battery corresponding to the first feature point; B3, performing a differential reciprocal dt/dV calculation on a voltage characteristic curve recorded in the current time period, and determining a second feature point of a differential reciprocal curve, where the second feature point is a peak position of dt/dV within a first voltage interval; and B4, calculating a second state of charge and a current state of health of the second-system battery corresponding to the second feature point.

As an alternative or addition to the above solution, in the method according to an embodiment of the disclosure, step C includes: C1, calculating a first capacity degradation of the second-system battery based at least on the first state of charge, the second state of charge, and the current state of health of the second-system battery; C2, calculating a capacity degradation of the first-system battery based at least on the first capacity degradation of the second-system battery, a dynamic balance amount of a state of charge interval of the first-system battery, and a dynamic balance amount of a state of charge interval of the second-system battery; and C3, calculating the current capacity and the state of health of the first-system battery based at least on the capacity degradation of the first-system battery and a nominal capacity of the first-system battery.

As an alternative or addition to the above solution, in the method according to an embodiment of the disclosure, in step C1, the first capacity degradation $C_{\Delta 1\_2}$ of the second-system battery is calculated using the following formula:

$$C_{\Delta 1\_2} = SOC_{1\_2} \times SOH_{1\_2} - SOC_{2\_2} \times SOH_{2\_2}$$

where $SOC_{1\_2}$ and $SOC_{2\_2}$ are respectively the first state of charge and the second state of charge of the second-system battery, $SOH_{1\_2}$ is an initial state of health of the second-system battery, and $SOH_{2\_2}$ is the current state of health of the second-system battery.

As an alternative or addition to the above solution, in the method according to an embodiment of the disclosure, in step C2, the capacity degradation $C_{aged\_1}$ of the first-system battery is calculated using the following formula:

$$C_{aged\_1} = \frac{C_{\Delta 1\_2} + C_{balance\_2} - C_{balance\_1}}{k}$$

where $C_{\Delta 1\_2}$ is the first capacity degradation of the second-system battery, $C_{balance\_1}$ and $C_{balance\_2}$ are respectively the dynamic balance amounts of the state of charge intervals of the first-system battery and the second-system battery, and $k$ is a preset constant quantity.

As an alternative or addition to the above solution, in the method according to an embodiment of the disclosure, if a time difference between the current time period and the initial time period is greater than or equal to a threshold duration, step B further includes: B5, determining a third feature point of a differential reciprocal curve for the voltage characteristic curve recorded in the initial time period, where the third feature point is a peak position of dt/dV within a second voltage interval, and a minimum value of the first voltage interval is greater than or equal to a maximum value of the second voltage interval; B6, calculating a third state of charge of the second-system battery corresponding to the third feature point; B7, determining a fourth feature point of a differential reciprocal curve for the voltage characteristic curve recorded in the current time period, where the fourth feature point is a peak position of dt/dV within the second voltage interval; and B8, calculating a fourth state of charge of the second-system battery corresponding to the fourth feature point.

As an alternative or addition to the above solution, in a method according to an embodiment of the disclosure, step C further includes: C4, calculating a second capacity degradation of the second-system battery based at least on the third state of charge, the fourth state of charge, and the current state of health of the second-system battery; C5, calculating a self-discharged capacity of the first-system battery based at least on the second capacity degradation of the second-system battery, a dynamic balance amount of a state of charge interval of the first-system battery, and a dynamic balance amount of a state of charge interval of the second-system battery; and C6, revising the current capacity of the first-system battery by using the self-discharged capacity.

As an alternative or addition to the above solution, in the method according to an embodiment of the disclosure, in step C4, the second capacity degradation $C_{\Delta 2\_2}$ of the second-system battery is calculated using the following formula:

$$C_{\Delta 2\_2} = SOC_{3\_2} \times SOH_{1\_2} - SOC_{4\_2} \times SOH_{2\_2}$$

where $SOC_{3\_2}$ and $SOC_{4\_2}$ are respectively the third state of charge and the fourth state of charge of the second-system battery, $SOH_{1\_2}$ is an initial state of health of the second-system battery, and $SOH_{2\_2}$ is the current state of health of the second-system battery.

As an alternative or addition to the above solution, in the method according to an embodiment of the disclosure, in step C5, the self-discharged capacity $C_{selfdischarged\_1}$ of the first-system battery is calculated using the following formula:

$$C_{selfdischarged\_1} = C_{\Delta 2\_2} + C_{balance\_2} - C_{balance\_1}$$

where $C_{\Delta 2\text{-}2}$ is the second capacity degradation of the second-system battery, and $C_{balance\_1}$ and $C_{balance\_2}$ are respectively the dynamic balance amounts of the state of charge intervals of the first-system battery and the second-system battery.

As an alternative or addition to the above solution, in the method according to an embodiment of the disclosure, in step C6, the current capacity of the first-system battery is revised using the following formula:

$$C_{revised\_1} = C_{current\_1} + C_{selfdischarged\_1}$$

where $C_{revised\_1}$ is a revised current capacity of the first-system battery, $C_{current\_1}$ is an unrevised current capacity, and $C_{selfdischarged\_1}$ is the self-discharged capacity.

As an alternative or addition to the above solution, in the method according to an embodiment of the disclosure, the first-system battery is a lithium iron phosphate-system battery, and the second-system battery is a nickel cobalt manganese-system battery.

According to a second aspect of the disclosure, there is provided a battery system including a first-system battery and a second-system battery, where a state of health (SOH) of the battery system is estimated by the following steps: A, performing constant-current charging on the battery system in an initial time period and a current time period, respectively, and recording a voltage characteristic curve for the first-system battery during the charging process; B, determining a feature point of a differential reciprocal dt/dV for the voltage characteristic curve, and calculating a state of charge and a state of health of the second-system battery corresponding to the feature point; and C, calculating a current capacity and a state of health of the first-system battery based at least on the state of charge and the state of health of the second-system battery.

According to a third aspect of the disclosure, there is provided a computer storage medium including instructions, where when the instructions are run, any one of the methods according to the first aspect of the disclosure is performed.

The state of health estimation solution according to one or more embodiments of the disclosure provides a novel approach to capacity degradation calculation, that is, the capacity degradation of the second-system battery is calculated by using the deviation in terms of the state of charge of the second-system battery (such as the nickel cobalt manganese-system battery) corresponding to a dt/dV feature point of the first-system battery (such as the lithium iron phosphate-system battery) in an initial state and a current usage state. In addition, the solution allows for more accurate estimation of the capacity degradation of the first-system battery by using the capacity degradation of the second-system battery, which is easy to calculate, thereby implementing accurate estimation of the state of health of the first-system battery without the need to fully charge the first-system battery.

## BRIEF DESCRIPTION OF THE DRAWINGS

The above-mentioned and/or other aspects and advantages of the disclosure will become more apparent and more readily appreciated from the following description of various aspects in conjunction with the accompanying drawings, in which the same or similar units are denoted by the same reference numerals. In the accompanying drawings:

FIG. 1 shows OCV-SOC curves for a lithium iron phosphate-system battery and a nickel cobalt manganese-system battery;

FIG. 2 is a schematic flowchart of an SOH estimation method 20 for a battery system according to an embodiment of the disclosure;

FIG. 3 is a schematic diagram of a voltage characteristic curve for a first-system battery according to an embodiment of the disclosure; and

FIG. 4 is a schematic diagram of a differential reciprocal dt/dV curve according to an embodiment of the disclosure.

## DETAILED DESCRIPTION OF EMBODIMENTS

A battery system including two systems of batteries, a state of health (SOH) estimation method for the battery system, and a computer storage medium according to the disclosure will be further described in detail below in conjunction with the accompanying drawings. It should be noted that the following descriptions of the specific embodiments are merely exemplary in nature, and are not intended to limit the disclosed technologies or the application and use of the disclosed technologies. In addition, there is no intention to be bound by any expressed or implied theory presented in the foregoing Technical Field and Background Art, or the following Detailed Description.

In the following detailed descriptions of the embodiments, many specific details are set forth to provide a more thorough understanding of the disclosed technologies. However, it is obvious for those of ordinary skill in the art that the disclosed technologies can be practiced without these specific details. In other instances, well-known features are not detailed, to avoid complicating the descriptions unnecessarily.

The terms such as "include" and "comprise" are used to indicate that in addition to units and steps that are directly and clearly described in this specification, other units and steps that are not directly or clearly described are not excluded in the technical solutions of the disclosure. The terms such as "first" and "second" are not used to indicate sequences of the units in terms of time, space, size, etc., and are merely used to distinguish between the units.

As described above, a battery system including a single lithium iron phosphate-system battery may have problems such as inaccurate state of health measurement and low energy efficiency. In view of this, the disclosure provides a battery system including a plurality of different systems of batteries (for example, including a first-system battery and a second-system battery), thereby enabling accurate estimation of the capacity degradation of the first-system battery by using the capacity degradation of the second-system battery, which is easy to calculate. In one embodiment, the first-system battery is a lithium iron phosphate-system battery (LFP), and the second-system battery is a nickel cobalt manganese-system battery (NCM), such that a dual-system battery system is formed. In the dual-system battery system, the lithium iron phosphate-system battery may be connected to the nickel cobalt manganese-system battery in series, where a ratio of lithium iron phosphate-system batteries to nickel cobalt manganese-system batteries in quantity may be 5 : 1, 3 : 1, 1 : 1, or the like.

FIG. 2 is a flowchart of an SOH estimation method 20 for a battery system according to an embodiment of the disclosure.

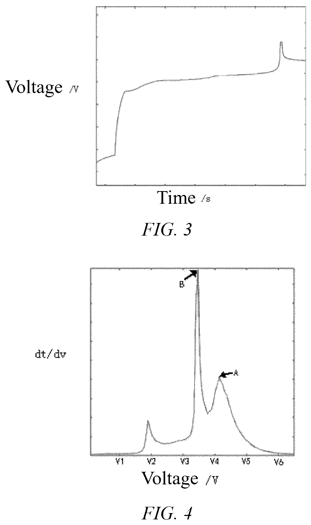

As shown in FIG. 2, in step S210, constant-current charging is performed on the battery system in an initial time period and a current time period, respectively, and a voltage characteristic curve for the first-system battery during the charging process is recorded. FIG. 3 shows an example of the voltage characteristic curve for the first-system battery according to an embodiment of the disclosure. Optionally, during the above-mentioned charging process, the constant current charging may be performed on the battery system at a current less than or equal to 1/3 C. The initial time period may be a calibration time period before the battery is shipped from the factory or any time period when it is not visibly used after being shipped from the factory. In addition, the current time period may be divided into a short-term usage time period and a long-term usage time period based on a time difference between the current time period and the initial time period. In an example, if the time difference between the current time period and the initial time period is greater than or equal to a threshold duration (for example, three months), the current time period is the long-term usage time period. If the time difference between the current time period and the initial time period is less than the threshold duration, the current time period is the short-term usage time period. The disclosure innovatively provides different SOH estimation methods for the short-term usage time period and the long-term usage time period. The SOH estimation method for the short-term usage time period will be described in detail below.

In step S220, a feature point of a differential reciprocal dt/dV for the voltage characteristic curve is determined, and a state of charge and a state of health of the second-system battery corresponding to the feature point are calculated.

Specifically, a differential reciprocal dt/dV calculation is first performed on the voltage characteristic curve for the first-system battery in step S210, that is, a differential reciprocal dt/dV calculation is performed on the voltage characteristic curve for the first-system battery that is recorded in the initial time period and the voltage characteristic curve for the first-system battery that is recorded in the current time period, respectively. FIG. 4 shows an example of a differential reciprocal dt/dV curve according to an embodiment of the disclosure. As shown in FIG. 4, as the first-system battery changes its voltage during the charging process, a differential reciprocal dt/dV curve of the voltage has a plurality of peaks and valleys. The inventors of the disclosure have found, after intensive research and extensive experiments, that a peak position of the differential reciprocal dt/dV curve of the voltage can represent the characteristic of the current state of health of the battery. Therefore, in some embodiments according to the disclosure, the peak position of the dt/dV curve is taken as the feature point of the dt/dV curve.

Optionally, for the differential reciprocal dt/dV curve in the initial time period, a peak position of the dt/dV curve within a specific voltage interval (for example, a first voltage interval) is selected as a first feature point. The selection of the above specific voltage interval is related to a common state of charge interval of the first-system battery. For example, a voltage range corresponding to the state of charge interval of 55%-75% of the first-system battery may be set to the first voltage interval, and the peak position of the dt/dV curve within the first voltage interval may be determined as the first feature point, for example, a feature point A as shown in FIG. 4. In the same way, for the differential reciprocal dt/dV curve in the current time period, a peak position of the dt/dV curve within the same voltage interval (for example, the above-described voltage range corresponding to the state of charge interval of 55%-75% of the first-system battery) is determined as a second feature point.

Next, a first state of charge $SOC_{1\_2}$ and a first state of health $SOH_{1\_2}$ of the second-system battery corresponding to the first feature point are calculated, that is, the first state of charge $SOC_{1\_2}$ and the first state of health $SOH_{1\_2}$ of the second-system battery when the first feature point occurs are calculated. A state of charge may be calculated based on state of charge calculation methods known in the art, and the methods include but are not limited to an SOC estimation method based on current integration and open-circuit voltage (OCV) calibration and an SOC estimation method based on a battery model. A state of health may be calculated based on state of health calculation methods known in the art, and the methods include but are not limited to a two-point method. In an embodiment, if the initial time period is a calibration time period before the battery is shipped from the factory, the first state of health of the second-system battery is an initial state of health of the second-system battery, i.e., $SOH_{1\_2} = 100\%$. In the same way, a second state of charge $SOC_{2\_2}$ and a current state of health $SOH_{2\_2}$ of the second-system battery corresponding to the second feature point are calculated.

Subsequently, in step S230, a current capacity and a state of health of the first-system battery are calculated based at least on the state of charge (for example, the first state of charge and the second state of charge that are calculated in step S220) and the state of health (for example, the initial state of health and the current state of health that are calculated in step S220) of the second-system battery. Optionally, step S230 includes S231 to 233.

In step S231, a first capacity degradation $C_{\Delta 1\_2}$ of the second-system battery is calculated based on the first state of charge $SOC_{1\_2}$, the second state of charge $SOC_{2\_2}$, the initial state of health $SOH_{1\_2}$, and the current state of health $SOH_{2\_2}$ of the second-system battery. In an example, the first capacity degradation $C_{\Delta 1\_2}$ of the second-system battery may be calculated using the following formula:

$$C_{\Delta1\_2} = SOC_{1\_2} \times SOH_{1\_2} - SOC_{2\_2} \times SOH_{2\_2} \qquad \text{(Formula 1)}$$

Since the capacity degradation of the battery system is mainly attributed to the aging of the battery during the short-term usage time period (i.e., the time difference between the current time period and the initial time period is less than the threshold duration (for example, three months)), the impact of a self-discharged capacity on the capacity degradation is negligible. In other words, for the short-term usage time period, the first capacity degradation $C_{\Delta1\_2}$ calculated in step S231 can reflect a capacity degradation of the second-system battery from the initial time period to the time of occurrence of the second feature point.

In step S232, a capacity degradation of the first-system battery is calculated based on the first capacity degradation $C_{\Delta1\_2}$ of the second-system battery, a dynamic balance amount of the state of charge interval of the first-system battery, and a dynamic balance amount of a state of charge interval of the second-system battery. It should be noted here that since different systems of batteries may have different degradation rates in the battery system including the plurality of systems of batteries, SOC intervals of different systems of batteries need to be dynamically balanced, such that an SOC interval of a system of battery in a multi-system battery system can always accurately reflect the overall state of charge of the battery system. The dynamic balance mode and the dynamic balance amount may be determined based on a dynamic balance method known in the art, which is not specifically limited or repeated in the disclosure.

It should be noted here that the inventors of the disclosure have found, after intensive research and extensive experiments, that a ratio of a capacity degradation of the battery before the occurrence of the second feature point within the first voltage interval (for example, the voltage range corresponding to the state of charge interval of 55%-75% of the first-system battery) to a total capacity degradation of the battery in the current time period is a constant value $k$. Thus, in an example, the capacity degradation $C_{aged\_1}$ of the first-system battery may be calculated using the following formula:

$$C_{aged\_1} = \frac{C_{\Delta1\_2} + C_{balance\_2} - C_{balance\_1}}{k} \qquad \text{(Formula 2)}$$

where $C_{\Delta1\_2}$ is the first capacity degradation of the second-system battery, and $C_{balance\_1}$ and $C_{balance\_2}$ are respectively the dynamic balance amounts of the state of charge intervals of the first-system battery and the second-system battery.

In step S233, the current capacity and the state of health of the first-system battery is calculated based on the capacity degradation $C_{aged\_1}$ of the first-system battery and a nominal capacity $C_{nominal\_1}$ of the first-system battery. For example, the current capacity $C_{current\_1}$ and the state of health $SOH_{current\_1}$ of the first-system battery can be calculated using the following formula:

$$C_{current\_1} = C_{nominal\_1} - C_{aged\_1} \qquad \text{(Formula 3),}$$

and

$$SOH_{current\_1} = \frac{C_{current\_1}}{C_{nominal\_1}} \qquad \text{(Formula 4).}$$

The process of estimating the current capacity and the state of health of the first-system battery for the short-term usage time period has been described above. However, for the long-term usage time period (i.e., the time difference between the current time period and the initial time period is greater than or equal to the threshold duration (for example, three months)), since the capacity degradation of the battery system is also affected by self-discharge, a self-discharged capacity needs to be calculated and is then used to revise the current capacity of the first-system battery. It should be noted here that the degradation of the first-system battery mainly occurs in a higher state of charge interval, while a capacity offset at a feature point within a lower state of charge interval can be attributed to self-discharge of the battery. Therefore, a capacity offset at a feature value can be calculated for the lower state of charge interval.

Optionally, the method 20 further includes: for the differential reciprocal dt/dV curve in the initial time period, selecting a peak position of the dt/dV curve within a lower voltage interval (for example, a second voltage interval) as a third feature point, for example, a feature point B as shown in FIG. 4. It should be appreciated that the first voltage interval described above is a higher voltage interval, and a minimum value of the first voltage interval is greater than or equal to a maximum value of the second voltage interval. For example, a voltage range corresponding to a state of charge interval of 35%-55% of the first-system battery may be set to the second voltage interval, and the peak position of the dt/dV curve within the second voltage interval is determined as the third feature point. In the same way, for the differential reciprocal dt/dV curve in the current time period, a peak position of the dt/dV curve within the same voltage interval (for example, the above-described voltage range corresponding to the state of charge interval of 35%-55% of the first-system battery) is determined as a fourth feature point. Next, a third state of charge of the second-system battery corresponding to the third feature point and a fourth state of charge of the second-system battery corresponding to the fourth feature point are calculated. A state of charge may be calculated based on state of charge calculation methods known in the art, and the methods include but are not limited to an SOC estimation method based on current integration and open-circuit voltage (OCV) calibration and an SOC estimation method based on a battery model. A state of health may be calculated based on state of health calculation methods known in the art, and the methods include but are not limited to a two-point method.

Subsequently, a second capacity degradation of the second-system battery is calculated based on the third state of charge $SOC_{3\_2}$, the fourth state of charge $SOC_{4\_2}$, the initial state of health $SOH_{1\_2}$, and the current state of health $SOH_{2\_2}$ of the second-system battery. In an example, the second capacity degradation $C_{\Delta2\_2}$ of the second-system battery may be calculated using the following formula:

$$C_{\Delta2\_2} = SOC_{3\_2} \times SOH_{1\_2} - SOC_{4\_2} \times SOH_{2\_2} \qquad \text{(Formula 5)}$$

Similar to step S232, a self-discharged capacity of the first-system battery is calculated based at least on the second capacity degradation $C_{\Delta2\_2}$ of the second-system battery, a dynamic balance amount $C_{balance\_1}$ of the state of charge interval of the first-system battery, and a dynamic balance amount $C_{balance\_2}$ of a state of charge interval of the second-system battery. In an example, the self-discharged capacity $C_{selfdischarged\_1}$ of the first-system battery is calculated using the following formula:

$$C_{selfdischarged\_1} = C_{\Delta2\_2} + C_{balance\_2} - C_{balance\_1} \qquad \text{(Formula 6)}$$

Finally, the current capacity of the first-system battery that is solved in step S233 is revised by using the self-discharged capacity. In an example, a revised current capacity $C_{revised\_1}$ and a revised state of health $SOH_{revised\_1}$ of the first-system battery may be calculated using the following formula:

$$C_{revised\_1} = C_{current\_1} + C_{selfdischarged\_1} \qquad \text{(Formula 7)}$$

$$SOH_{revised\_1} = \frac{C_{revised\_1}}{C_{nominal\_1}} \qquad \text{(Formula 8)}$$

As described above, the state of health (SOH) estimation method according to the disclosure provides a novel approach to capacity degradation calculation, that is, the capacity degradation of the second-system battery is calculated by using the deviation in terms of the state of charge of the second-system battery (such as the nickel cobalt manganese-system battery) corresponding to a dt/dV feature point of the first-system battery (such as the lithium iron phosphate-system battery) in an initial state and a current usage state. In addition, the method allows for more accurate estimation of the capacity degradation of the first-system battery by using the capacity degradation of the second-system battery, which is easy to calculate, thereby implementing accurate estimation of the state of health of the first-system battery without the need to fully charge the first-system battery.

According to another aspect of the disclosure, there is further provided a battery system including a first-system battery and a second-system battery. In one embodiment, the first-system battery is a lithium iron phosphate-system battery (LFP), and the second-system battery is a nickel cobalt manganese-system battery (NCM), such that a dual-system battery system is formed. In the dual-system battery system, the lithium iron phosphate-system battery may be connected to the nickel cobalt manganese-system battery in series, where a ratio of lithium iron phosphate-system batteries to nickel cobalt manganese-system batteries in quantity may be 5 : 1, 3 : 1, 1 : 1, or the like. To estimate the state of health (SOH) of the first-system battery, constant-current charging is performed on the battery system in an initial time period and a current time period, respectively, and a voltage characteristic curve for the first-system battery during the charging process is recorded; a feature point of a differential reciprocal dt/dV for the voltage characteristic curve is determined, and a state of charge and a state of health of the second-system battery corresponding to the feature point are calculated; and a current capacity and a state of health of the first-system battery are calculated based at least on the state of charge and the state of health of the second-system battery.

In addition, as described above, the disclosure may also be implemented as a computer storage medium, in which a program for causing a computer to perform the method as shown in FIG. 2 is stored. Here, various forms of computer storage media, for example, a disk (for example, a magnetic disk and an optical disc), a card (for example, a memory card and an optical card), a semiconductor memory (for example, a ROM and a non-volatile memory), and a tape (for example, a magnetic tape and a cassette tape), may be used as the computer storage medium.

## EP 4 553 520 A1

Various embodiments provided in the disclosure may be implemented by hardware, software, or a combination of hardware and software where applicable. In addition, without departing from the scope of the disclosure, various hardware components and/or software components described herein may be combined into a combined component including software, hardware, and/or both where applicable. Without departing from the scope of the disclosure, various hardware components and/or software components described herein may be separated into sub-components including software, hardware, or both where applicable. In addition, where applicable, it is contemplated that software components can be implemented as hardware components, and vice versa.

Software (such as program code and/or data) in the disclosure may be stored on one or more computer storage media. It is also contemplated that the software identified herein can be implemented using one or more general-purpose or special-purpose computers and/or computer systems, networked and/or otherwise. The steps described herein can be changed in order, combined into compound steps, and/or divided into sub-steps where applicable, to provide the features described herein.

The embodiments and examples proposed herein are provided to describe as adequately as possible embodiments according to the disclosure and specific applications thereof and thus enable those skilled in the art to implement and use the disclosure. However, those skilled in the art will know that the above descriptions and examples are provided only for description and illustration. The proposed description is not intended to cover all aspects of the disclosure or limit the disclosure to the disclosed precise forms.

**Claims**

1.  A state of health (SOH) estimation method for a battery system, wherein the battery system comprises a first-system battery and a second-system battery, the method comprising:

    A, performing constant-current charging on the battery system in an initial time period and a current time period, respectively, and recording a voltage characteristic curve for the first-system battery during the charging process;
    B, determining a feature point of a differential reciprocal dt/dV for the voltage characteristic curve, and calculating a state of charge and a state of health of the second-system battery corresponding to the feature point; and
    C, calculating a current capacity and a state of health of the first-system battery based at least on the state of charge and the state of health of the second-system battery.

2.  The method according to claim 1, wherein step B comprises:

    B1, performing a differential reciprocal dt/dV calculation on a voltage characteristic curve recorded in the initial time period, and determining a first feature point of a differential reciprocal curve, wherein the first feature point is a peak position of dt/dV within a first voltage interval;
    B2, calculating a first state of charge of the second-system battery corresponding to the first feature point;
    B3, performing a differential reciprocal dt/dV calculation on a voltage characteristic curve recorded in the current time period, and determining a second feature point of a differential reciprocal curve, wherein the second feature point is a peak position of dt/dV within a first voltage interval; and
    B4, calculating a second state of charge and a current state of health of the second-system battery corresponding to the second feature point.

3.  The method according to claim 2, wherein step C comprises:

    C1, calculating a first capacity degradation of the second-system battery based at least on the first state of charge, the second state of charge, and the current state of health of the second-system battery;
    C2, calculating a capacity degradation of the first-system battery based at least on the first capacity degradation of the second-system battery, a dynamic balance amount of a state of charge interval of the first-system battery, and a dynamic balance amount of a state of charge interval of the second-system battery; and
    C3, calculating the current capacity and the state of health of the first-system battery based at least on the capacity degradation of the first-system battery and a nominal capacity of the first-system battery.

4.  The method according to claim 3, wherein in step C1, the first capacity degradation $C_{\Delta 1\_2}$ of the second-system battery is calculated using the following formula:

$$C_{\Delta 1\_2} = SOC_{1\_2} \times SOH_{1\_2} - SOC_{2\_2} \times SOH_{2\_2}$$

wherein $SOC_{1\_2}$ and $SOC_{2\_2}$ are respectively the first state of charge and the second state of charge of the second-system battery, $SOH_{1\_2}$ is an initial state of health of the second-system battery, and $SOH_{2\_2}$ is the current state of health of the second-system battery.

5. The method according to claim 4, wherein in step C2, the capacity degradation $C_{aged\_1}$ of the first-system battery is calculated using the following formula:

$$C_{aged\_1} = \frac{C_{\Delta 1\_2} + C_{balance\_2} - C_{balance\_1}}{k}$$

wherein $C_{\Delta 1\_2}$ is the first capacity degradation of the second-system battery, $C_{balance\_1}$ and $C_{balance\_2}$ are respectively the dynamic balance amounts of the state of charge intervals of the first-system battery and the second-system battery, and k is a preset constant quantity.

6. The method according to claim 2, wherein if a time difference between the current time period and the initial time period is greater than or equal to a threshold duration, step B further comprises:

B5, determining a third feature point of a differential reciprocal curve for the voltage characteristic curve recorded in the initial time period, wherein the third feature point is a peak position of dt/dV within a second voltage interval, and a minimum value of the first voltage interval is greater than or equal to a maximum value of the second voltage interval;
B6, calculating a third state of charge of the second-system battery corresponding to the third feature point;
B7, determining a fourth feature point of a differential reciprocal curve for the voltage characteristic curve recorded in the current time period, wherein the fourth feature point is a peak position of dt/dV within the second voltage interval; and
B8, calculating a fourth state of charge of the second-system battery corresponding to the fourth feature point.

7. The method according to claim 6, wherein step C further comprises:

C4, calculating a second capacity degradation of the second-system battery based at least on the third state of charge, the fourth state of charge, and the current state of health of the second-system battery;
C5, calculating a self-discharged capacity of the first-system battery based at least on the second capacity degradation of the second-system battery, a dynamic balance amount of a state of charge interval of the first-system battery, and a dynamic balance amount of a state of charge interval of the second-system battery; and
C6, revising the current capacity of the first-system battery by using the self-discharged capacity.

8. The method according to claim 7, wherein in step C4, the second capacity degradation $C_{\Delta 2\_2}$ of the second-system battery is calculated using the following formula:

$$C_{\Delta 2\_2} = SOC_{3\_2} \times SOH_{1\_2} - SOC_{4\_2} \times SOH_{2\_2}$$

wherein $SOC_{3\_2}$ and $SOC_{4\_2}$ are respectively the third state of charge and the fourth state of charge of the second-system battery, $SOH_{1\_2}$ is an initial state of health of the second-system battery, and $SOH_{2\_2}$ is the current state of health of the second-system battery.

9. The method according to claim 7, wherein in step C5, the self-discharged capacity $C_{selfdischarged\_1}$ of the first-system battery is calculated using the following formula:

$$C_{selfdischarged\_1} = C_{\Delta 2\_2} + C_{balance\_2} - C_{balance\_1}$$

wherein $C_{\Delta 2\_2}$ is the second capacity degradation of the second-system battery, and $C_{balance\_1}$ and $C_{balance\_2}$ are respectively the dynamic balance amounts of the state of charge intervals of the first-system battery and the second-system battery.

10. The method according to claim 7, wherein in step C6, the current capacity of the first-system battery is revised using the following formula:

$$C_{revised\_1} = C_{current\_1} + C_{selfdischarged\_1}$$

wherein $C_{revised\_1}$ is a revised current capacity of the first-system battery, $C_{current\_1}$ is an unrevised current capacity, and $C_{selfdischarged\_1}$ is the self-discharged capacity.

11. The method according to any one of claims 1 to 10, wherein the first-system battery is a lithium iron phosphate-system battery, and the second-system battery is a nickel cobalt manganese-system battery.

12. A battery system, comprising a first-system battery and a second-system battery, wherein a state of health (SOH) of the battery system is estimated by the following steps:

A, performing constant-current charging on the battery system in an initial time period and a current time period, respectively, and recording a voltage characteristic curve for the first-system battery during the charging process;
B, determining a feature point of a differential reciprocal dt/dV for the voltage characteristic curve, and calculating a state of charge and a state of health of the second-system battery corresponding to the feature point; and
C, calculating a current capacity and a state of health of the first-system battery based at least on the state of charge and the state of health of the second-system battery.

13. A computer storage medium having instructions stored therein, wherein the instructions, when executed by a processor, cause the processor to perform the method according to any one of claims 1 to 11.

Nickel cobalt manganese-system battery

OCV / V

Lithium iron phosphate-system battery

SOC / %

*FIG. 1*

S210

S220

S230

20

*FIG. 2*

Voltage /V

Time /s

*FIG. 3*

dt/dv

B

A

V1  V2  V3  V4  V5  V6

Voltage /V

*FIG. 4*

## INTERNATIONAL SEARCH REPORT

| International application No. |
|---|
| **PCT/CN2023/104874** |

| A. | CLASSIFICATION OF SUBJECT MATTER |
|---|---|

G01R31/382(2019.01)i

According to International Patent Classification (IPC) or to both national classification and IPC

| B. | FIELDS SEARCHED |
|---|---|

Minimum documentation searched (classification system followed by classification symbols)

IPC：G01R31

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT; IEEE: 蔚来, 万智文, 何腾, 蔡伟, 花睿, 曾士哲, 电池, 健康状态, 体系, 电压, 特征点, 微分, 导数, 荷电状态, 容量, SOH, SOC, battery, state of health, state of charge, voltage, feature, characteristic, differential, capacity

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 111766524 A (ZHEJIANG JIZHI NEW ENERGY AUTOMOBILE TECHNOLOGY CO., LTD. et al.) 13 October 2020 (2020-10-13)<br>claims 1-10, and description, paragraphs [0054]-[0092] | 1-13 |
| A | CN 112698223 A (NIO AUTOMOBILE TECHNOLOGY (ANHUI) CO., LTD.) 23 April 2021 (2021-04-23)<br>entire document | 1-13 |
| A | CN 106461732 A (RENAULT S.A.S) 22 February 2017 (2017-02-22)<br>entire document | 1-13 |
| A | CN 103003710 A (ROBERT BOSCH CO., LTD.) 27 March 2013 (2013-03-27)<br>entire document | 1-13 |
| A | JP 2019045351 A (MITSUBISHI MOTORS CORP.) 22 March 2019 (2019-03-22)<br>entire document | 1-13 |
| A | WO 2013157132 A1 (HITACHI VEHICLE ENERGY, LTD. et al.) 24 October 2013 (2013-10-24)<br>entire document | 1-13 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 September 2023** | **01 October 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

| International application No. |
| --- |
| **PCT/CN2023/104874** |

| Patent document cited in search report | | | Publication date (day/month/year) | Patent family member(s) | Publication date (day/month/year) |
| --- | --- | --- | --- | --- | --- |
| CN | 111766524 | A | 13 October 2020 | None | |
| CN | 112698223 | A | 23 April 2021 | None | |
| CN | 106461732 | A | 22 February 2017 | None | |
| CN | 103003710 | A | 27 March 2013 | None | |
| JP | 2019045351 | A | 22 March 2019 | None | |
| WO | 2013157132 | A1 | 24 October 2013 | None | |

Form PCT/ISA/210 (patent family annex) (July 2022)